**Europäisches Patentamt**

**European Patent Office**

**Office européen des brevets**

(19)

(11) Publication number:

**0 048 805**

**B1**

(12) **EUROPEAN PATENT SPECIFICATION**

(45) Date of publication of patent specification: **22.05.85**

(51) Int. Cl.⁴: **H 01 L 27/14, G 06 K 7/10**

(21) Application number: **81106125.8**

(22) Date of filing: **05.08.81**

(54) **Semiconductor integrated circuit optical image-to-electrical signal transducer.**

(30) Priority: **29.09.80 US 191553**

(43) Date of publication of application:
**07.04.82 Bulletin 82/14**

(45) Publication of the grant of the patent:
**22.05.85 Bulletin 85/21**

(84) Designated Contracting States:
**DE FR GB IT**

(56) References cited:
**DE-A-2 440 325**
**DE-A-2 647 274**
**US-A-3 452 206**
**US-A-3 909 520**
**US-A-4 063 268**

**IEEE TRANSACTIONS ON ELECTRON DEVICES**
**Vol. ED-25, No. 2, February 1978 New York F.**
**BARBE et al. "Signal Processing with Charge-Coupled-Devices"**

(73) Proprietor: **International Business Machines Corporation**
**Old Orchard Road**
**Armonk, N.Y. 10504 (US)**

(72) Inventor: **Chamberlain, Savvas Georgiou**
**52 Academy Crescent**
**Waterloo Ontario, N2L 5H7 (CA)**
Inventor: **Rutz, Richard Frederick.**
**RT 2, Box 70**
**Cold Spring New York 10516 (US)**

(74) Representative: **Hobbs, Francis John**
**IBM United Kingdom Patent Operations Hursley Park**
**Winchester, Hants, SO21 2JN (GB)**

Courier Press, Leamington Spa, England.

EP 0 048 805 B1

## Description

This invention relates to semiconductor integrated circuit optical image-to-electrical signal transducers wherein quantities of light striking photo responsive regions in an array are converted to an output signal that electrically corresponds to the light quantities.

Solid state charge-coupled output imagers and scanners made in silicon, have been well known for their good light sensitivity, dynamic range, and ease of fabrication. These devices use photodiodes which generate carriers in response to light input. An integrated array structure which stores the charge and then transfers it to a charge-coupled device register is shown in the *IEEE Transactions on Electron Devices*, Vol. ED 25, February 1978 and in US—A—4,142,198 and US—A—4,168,444. In these arrays, however, the photoelement employed provides less than a desirable quantum efficiency in the short wavelength range of the visible spectrum. Such a limitation results in a need for increasing the exposure time to integrate the light generated carriers in order to detect low light levels and this in turn imposes a limit on the video output data rate.

US—A—4,078,243 discloses a phototransistor array which is suitable for relatively low light levels in that it provides amplification of the electrical charge signals produced when the surface of the array is illuminated.

A semiconductor integrated circuit optical image-to-electrical signal transducer comprising an array of phototransistors each capable of converting photons to an electrical charge signal and amplifying that charge signal to produce an amplified electrical charge signal, is characterised, according to the invention, in that the transducer further comprises a parallel-to-serial signal converter which is responsive to the receipt in parallel of the amplified electrical charge signals from said array to produce a serial electrical output signal representing an optical image directed at the array, the collectors of the phototransistors and the parallel-to-serial signal converter being formed in a common layer of semiconductor material formed on a semi-insulating substrate.

How the invention can be carried out will now be described by way of example, with reference to the accompanying drawings, in which:—

FIG. 1 is a schematic illustration showing the transfer of light to a printed representation;

FIG. 2 is a three-dimensional schematic showing the arrangement of the layers in an integrated structure according to the invention;

FIG. 3 is a metallization and electrical schematic diagram illustrating the metallization on the integrated structure of FIG. 2 and the electrical connections for its operation; and

FIG. 4 is a timing chart for its operation.

The invention involves an integrated semiconductor array, a photon responsive carrier generating device with gain such as a vertical phototransistor which provides the current gain of a bipolar transistor and which is constructed with the collector thereof in the same integrated semiconductor layer as the charge-elements of a charge-coupled device output register which serves as a parallel to serial electrical signal converter. The resulting structure has the features that the photoelement has inherent current gain. The inherent current gain also provides good quantum efficiency at the short wavelength range of the visible spectrum. This in turn reduces the exposure time to get a sufficient charge from the light input and thus a high speed video output rate is achieved at low light levels.

In a structure embodying the invention, a semi-insulating substrate supports a first conductivity type layer that is common to both the location area of the photoelement and the location area of the charge-coupled device output shift register. In the photosensitive device area a region of opposite conductivity is provided and within that region a smaller region of the same conductivity is provided thereby producing a vertical bipolar transistor, wherein the centre or base region is floating and the surface region corresponding to the emitter is highly doped and set at a potential which is less than the potential applied to the substrate layer. This floating base bipolar transistor structure is a highly sensitive photoelement with a current gain. The reverse bias for the base-to-collector junction is provided internally in the structure when the lower layer is depleted of carriers. In such a structure since the emitter-base junction is forward biased when light is incident on the base region thereof, the photocurrent created in the presence of light acts as a constant base current causing the transistor to operate in the normal mode thereby amplifying the photocurrent. The amplified photocurrent in turn builds up charges in the region serving as the collector, and, through a series of gates which permit integration and storage of the photocharge, the charge is transferred at a specific time and thus in conventional charge-coupled device shift register fashion the charge is converted to an electrical output signal.

A modification is provided to a standard charge-coupled device type of output shift register in that asymmetry in current flow is imparted between device elements of the shift register by the introduction of barriers which provide unidirectional signal charge flow. The resulting device is a highly light sensitive optical-to-electrical transducer with the added capability of using only a two-phase clock.

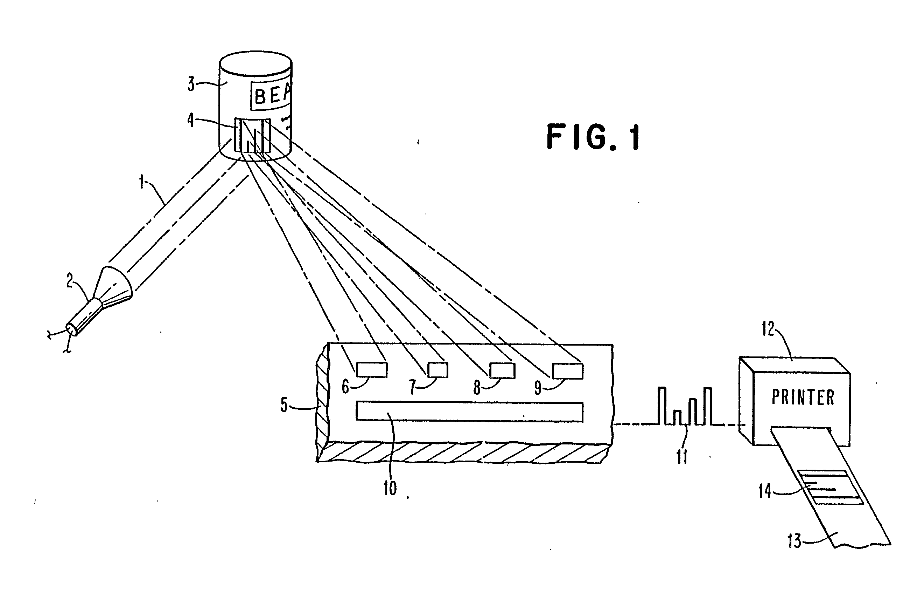

Referring now to FIG. 1 there is provided a schematic diagram of the conversion of an increment of optical information into an electrical signal employing the imaging device of the invention.

In FIG. 1 light 1 from a source 2 is directed to an object 3 illustrated as a can and having thereon an information pattern 4 to be converted to an electrical signal. The pattern 4 is a schematic replica of a standard bar code for content and price information used in commerce and an illus-

trative four segment portion thereof has the individual light elements thereof reflected so as to impinge the imaging device 5 embodying the invention. In the device 5 there are photosensitive segments 6 through 9 and an output register 10 so that the light increments striking elements 6 through 9 are translated through the register element 10 into a pulse pattern signal 11 which is a replica of the bar code 4 and which in turn operates to drive a print mechanism 12 to produce on a tape 13 an ink configuration 14 corresponding to the elements of the pulse pattern 11 and of the bar code 4.

Integrated optical-to-electrical transducers such as 5 in FIG. 1 that have been available heretofore in the art, have had two serious limitations. One is that the optical response of the transducer in the short wavelength end of the light spectrum operates to slow down the rate at which the information can be read out of the device where light levels are low. The second is that the devices have been using registers that are unduly complicated and large numbers of clocked phases were required to move the information in sequence.

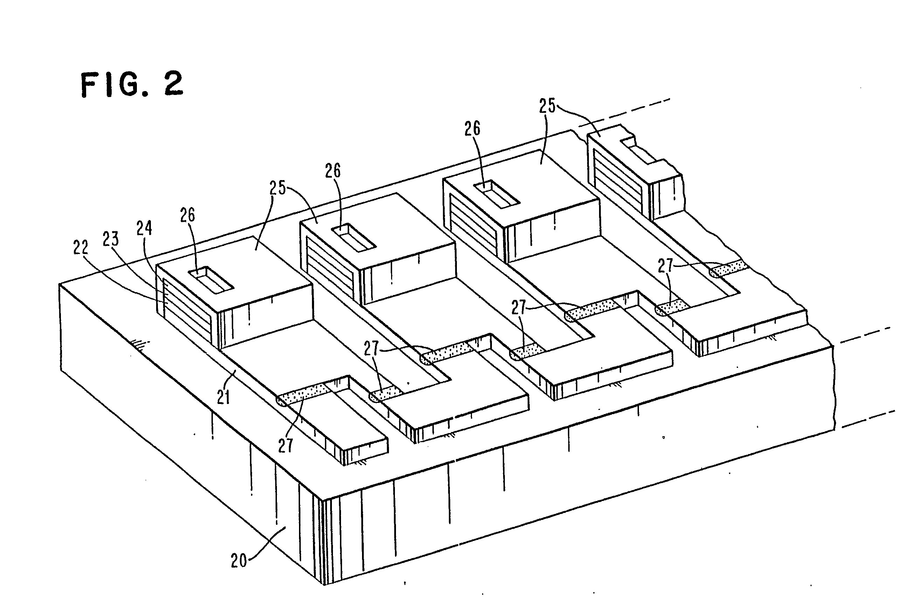

Referring next to FIG. 2, a three-dimensional illustration is provided of the integrated structure of the invention wherein the features are set forth in the integrated technology.

While it will be apparent to anyone skilled in the art that in the light of the principles set forth many semi-conductor materials with different conducting types will be found to meet the invention criteria, the description will be couched in terms of the preferred embodiment, gallium arsenide, which is well known for its optical-electrical conversion properties and specific conductivity types are assigned.

An insulating gallium arsenide substrate 20 is provided as is standard in the art for a situation in which active devices are to be epitaxially grown on a base which electrically will take no part in the operation. On the substrate 20 a layer 21 of n-conductivity type gallium arsenide is provided which will serve the purpose of the collector of the phototransistor and an electrode of the charge-coupled device output shift register. In the region of the photoresponsive area a region of p-conductivity type gallium arsenide 22 is applied over the layer 21. Over the p-region 22 a subsequent n-region of gallium arsenide 23 is applied. The structure thus produced provides a vertical bipolar transistor in which the region 23 is the emitter, the region 22 is the base, and the region 21 serves as the collector. The region 23 will be doped more heavily than the region 21. For optical enhancement purposes, especially in the blue or short wavelength range of the spectrum, a window layer 24 of gallium aluminum arsenide is provided over the region 23. A region 25 of silicon dioxide is provided for passivation and enhanced light absorption purposes and there is included an opening 26 for biasing electrode connection purposes.

The layer 21 is also provided, in the portion for use as the charge-coupled device shift register, with a series of asymmetric impedance regions 27 which serve as barriers and operate to provide unidirectional charge transfer between the elements of the charge-coupled device register. The barriers 27 may be conveniently produced by ion implanting donors into the regions of the n-conductivity type gallium arsenide layer 21.

In operation of the structure of FIG. 2, light passing through the layers 25 and 24 is converted to an amplified electrical signal and transferred out through the output shift register, the segments of which are separated by the barriers 27.

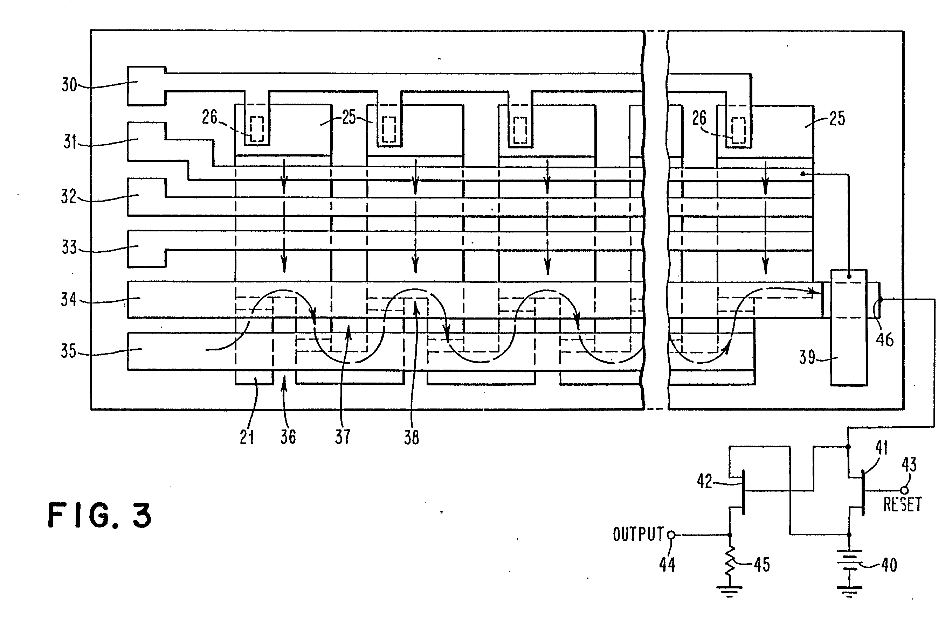

Referring next to FIG. 3 a further schematic is provided illustrating the metallized conductors that in response to a clock signal move the changes and an output and reset circuit.

In FIG. 3 a bias metallization electrode 30 is provided which will be connected to a positive voltage and has fingers which make contact in the openings 26 to each of the photo-responsive elements. A barrier gate 31 is provided forming a thin metal Schottky barrier rectifying connection with each of the n-regions 21 and is shown as a stripe positioned perpendicular to the regions 21 adjacent to the photoelement region between the photoelement and the charge-coupled device region. A storage gate 32, again forming a metal Schottky barrier at each intersection with the layer 21, is next provided between the gate 31 and the charge-coupled device region. The barrier gate 31 and the storage gate 32 function in combination to even out the output and to permit integrating of the charge produced by the light that strikes the device elements. A transfer gate 33 is next provided, again forming a metal Schottky barrier at each intersection with the segments of the layer 21 and positioned between the storage gate 32 and the charge-coupled device so that upon a proper signal the charge stored in the storage region of the segment of the layer 21 associated with each phototransistor can be transferred to the charge-coupled array shift register. Clock eleectrodes 34 and 35, respectively, are provided for the charge movement in the shift register so that upon application of a signal the stored charge in the charge-coupled device segments provided by the cutouts 36 and 37 of the layer 21 are transferred as shown by the arrow 38 with back charge migration prevented by the implanted impedances 27.

The output and reset capability is provided through a sensing electrode 46 connected to a circuit such that 2 FET transistor gate paths are provided in parallel.

The output and reset circuit employs a voltage source 40 having one terminal connected to ground or common and having the opposite polarity terminal supplying potential to the drain electrode of reset transistor 41 and to the drain electrode of output transistor 42. The reset input signal is applied at the gate 43 of the reset transistor. The output is developed at electrode 44 across impedance 45 having the other terminal thereof connected to earth. The output 44 is connected to the source electrode of the output transistor, the gate thereof being connected to sensing electrode 46.

In operation, assuming the voltage source 40 supplies +13 volts to the drain of reset transistor 41 and to the drain of output transistor 42, the signal illustrated by arrow 38 will be delivered at terminal 44. When reset is desired, a +13V signal at terminal 43 operates to fix the sensing electrode 46 and the gate of transistor 42 at about 13 V, thereby terminating any output signal and draining off any stored charge in the output register.

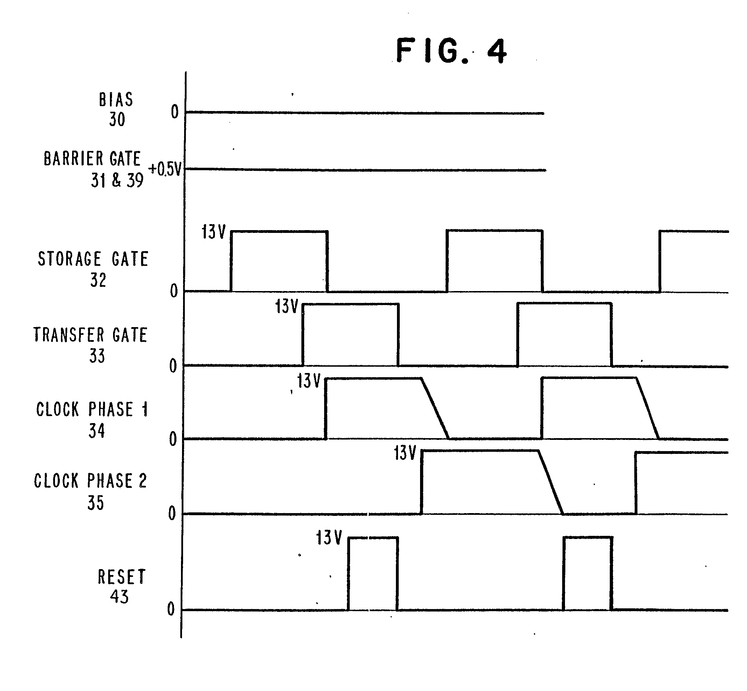

Referring next to FIG. 4 a timing chart is provided wherein the respective timing pulses assuming voltages of +13 Volts are illustrated. The bias gate 30 is shown connected to a steady state 0 Volts. The barrier gate 31 is connected at a positive level with respect to the substrate for example, 0.5 Volts. The signal at the storage gate 32 is shown increasing from zero to the 13 Volt level shown for the bias gate at intervals which are largely governed by the charge integration time of the photosensitive element. (This time will be shorter than required for the same light input of all previous prior art devices that did not have the gain of a transistor.) The signal on the transfer gate 33 increases from zero to the +13 Volts at a time when the integrated light generated charge on the storage gate has achieved a high level and remains long enough to transfer the energy into the transfer elements of the charge-coupled device. The clock gates 34 and 35, respectively, of the charge-coupled device are labelled Phase 1 and Phase 2. Phase 1 comes on at 13 V during the operation of the transfer gate and remains "on" until all charge is removed. Phase 2 comes "on" at the trailing part of Phase 1 and goes "off" with the rise of Phase 1. The signal on the reset 43, and so on sensing electrode 46, is shown as going from zero to 13 Volts at the end of each charge increment transfer.

The optical-to-electrical transducer of the invention may be fabricated using well known semiconductor integrated circuit manufacturing techniques such as vapour phase epitaxy, ion implantation and diffusion. The substrate 20 may be high resistivity chromium doped gallium arsenide formed through the technique of chemical vapour deposition. The n-region 21 may be epitaxially grown gallium arsenide with the doping level of around $10^{17}$ tellurium donors per cc. The layer 21 could conveniently be about 1 micron deep over the entire substrate with growth prevented in the slots 37 and 38 by standard growth masking techniques or, alternatively, by growing over the entire substrate and using standard photolithographic and etching techniques. The p-type gallium arsenide layer 22 and the n+-type gallium arsenide layer 23 may be grown with a doping density of about $10^{17}$ atoms/cc to a thickness of about 0.2 microns in the selected area desired by masking. The window of gallium aluminum arsenide 24 may be adjusted such that the aluminum quantity is 0.3 and the arsenic quantity is 0.7. With this layer 24 surface recombination is reduced and photoresponse is enhanced especially in the blue wavelength region.

An alternative method of manufacture would be to grow all layers over the entire area and then by standard photolithographic masking and etching procedures the phototransistor array elements could be formed by etching out to the original n-region 21. For this purpose a non-preferential etch such as the standard 40 parts hydrochloric acid, 1 part hydrogen peroxide and 1 part water can be used.

A silicon dioxide passivation layer is then applied by chemical vapour deposition over the entire array and the gates 30 to 35 applied by standard metal evaporation techniques where the metal is Al or other well known Schottky gate metals and deposited about 300 Å thick.

What has been described is an optical-to-electrical transducer having gain and requiring only two clock phases. The optical-to-electrical transducer has light responsive electrical charge generation with electrical signal amplification, the capability to integrate the light generated signal to a selected magnitude and the ability to convert a plurality of individual signals into a serial electrical representation.

**Claims**

1. A semiconductor integrated circuit optical image-to-electrical signal transducer comprising an array of phototransistors (21, 22, 23) each capable of converting photons to an electrical charge signal and amplifying that charge signal to produce an amplified electrical charge signal, characterised in that the transducer further comprises a parallel-to-serial signal converter (21, 32, 33, 34, 35) which is responsive to the receipt in parallel of the amplified electrical charge signals from said array to produce a serial electrical output signal representing an optical image directed at the array, the collectors of the phototransistors and the parallel-to-serial signal converter being formed in a common layer (21) of semiconductor material formed on a semi-insulating substrate (20).

2. An optical image-to-electrical signal transducer as claimed in claim 1, in which means (30) are provided for electrically biasing the phototransistors.

3. An optical image-to-electrical signal transducer as claimed in claim 2, in which no connections are made to the base regions (22) of the phototransistors so that the potentials of the base regions float in operation of the transducer.

4. An optical image-to-electrical signal transducer as claimed in any preceding claim, in which the parallel-to-serial signal converter is a charge-coupled device shift register.

5. An optical image-to-electrical signal transducer as claimed in any preceding claim, including means (31) to produce a potential well between the array and the parallel-to-serial signal converter to enhance the light sensitivity of the transducer.

6. An optical image-to-electrical signal transducer as claimed in any preceding claim, which is a gallium arsenide integrated circuit.

**Patentansprüche**

1. Als integrierte Halbleiterschaltung ausgebildeter Wandler zur Umwandlung eines optischen Bildsignals in ein elektrisches Signal, mit einem Feld von Phototransistoren (21, 22, 23), von denen jeder Photonen in ein elektrisches Ladungssignal umwandeln und dieses Ladungssignal zur Erzeugung eines verstärkten elektrischen Ladungssignals verstärken kann, dadurch gekennzeichnet, daß der Wandler ferner einen Parallel-Seriell-Signalumsetzer (21, 32, 33, 34, 35) aufweist, welcher auf einen Parallelempfang der verstärkten elektrischen Ladungssignale aus dem Feld mit der Erzeugung eines seriellen elektrischen Ausgangssignals, welches ein auf das Feld gerichtetes optisches Bild darstellt, anspricht, wobei die Kollektoren der Phototransistoren und der Parallel-Seriell-Signalumsetzer auf einer auf einem halbisolierenden Substrat (20) ausgebildeten gemeinsamen Schicht (21) aus Halbleitermaterial ausgebildet sind.

2. Wandler zur Umwandlung eines optischen Bildsignals in ein elektrisches signal nach Anspruch 1, bei welchem Mittel (30) zum elektrischen Vorspannen der Transistoren vorgesehen sind.

3. Wandler zur Umwandlung eines optischen Bildsignals in ein elektrisches Signal nach Anspruch 2, bei welchem keine Verbindungen zu den Basisbereichen (22) der Phototransistoren hergestellt sind, so daß die Potentiale der Basisbereiche beim Betrieb des Wandlers frei sind.

4. Wandler zur Umwandlung eines optischen Bildsignals in ein elektrisches Signal nach irgendeinem vorstehenden Anspruch, bei welchem der Parallel-Seriell-Signalumsetzer ein Ladungsverschiebeelement-Schieberegister ist.

5. Wandler zur Umwandlung eines optischen Bildsignals in ein elektrisches Signal nach irgendeinem vorstehenden Anspruch, welcher Mittel (31) zur Erzeugung einer Potentialsenke zwischen dem Feld und dem Parallel-Seriell-Signalumsetzer zur Erhöhung der Lichtempfindlichkeit des Wandlers aufweist.

6. Wandler zur Umwandlung eines optischen Bildsignals in ein elektrisches Signal nach irgendeinem vorstehenden Anspruch, welcher eine integrierte Schaltung auf Galliumarsenid-Basis ist.

**Revendications**

1. Transducteur d'images optiques en signaux électriques à circuit intégré à semiconducteurs comprenant un groupement de phototransistors (21, 22, 23) dont chacun est apte à convertir des photons en un signal de charge électrique et à amplifier ce signal de charge pour fournir un signal de charge électrique amplifié, caractérisé en ce que le transducteur comprend en outre un convertisseur de signaux parallèle-série (21, 32, 33, 34, 35) qui réagit à la réception en parallèle des signaux de charge électrique amplifiés provenant dudit groupement pour fournir un signal de sortie électrique série représentant une image optique dirigée sur le groupement, les collecteurs des phototransistors et le convertisseur de signaux parallèle-série étant formés dans une couche commune (21) de matériau semiconducteur formée sur un substrat semi-isolant (20).

2. Transducteur d'images optiques en signaux électriques selon la revendication 1, dans lequel des moyens (30) sont prévus pour polariser électriquement les phototransistors.

3. Transducteur d'images optiques en signaux électriques selon la revendication 2, dans lequel aucune connexion n'aboutit aux régions de base (22) des phototransistors, de sorte que les potentiels des régions de base flottent lors du fonctionnement du transducteur.

4. Transducteur d'images optiques en signaux électriques selon l'une quelconque des revendications précédentes, dans lequel le convertisseur de signaux parallèle-série est un registre à décalage à dispositif à couplage de charge.

5. Transducteur d'images optiques en signaux électriques selon l'une quelconque des revendications précédentes, comportant des moyens (31) propres à créer un puits de potentiel entre le groupement et le convertisseur de signaux parallèle-série afin d'accroître la photo-sensibilité du transducteur.

6. Transducteur d'images optiques en signaux électriques selon l'une quelconque des revendications précédentes, qui est un circuit intégré à l'arséniure de gallium.

FIG. 1

3

BEA

4

1

2

6 7 8 9

5

10

11

12

PRINTER

14

13

0 048 805

# FIG. 2

FIG. 3

0 048 805

FIG. 4